# EUROPÄISCHE PATENTSCHRIFT

(11) **EP 3 008 753 B1**
(45) Veröffentlichungstag und Bekanntmachung des Hinweises auf die Patenterteilung: **23.11.2016**
(21) Anmeldenummer: 14726506.0
(22) Anmeldetag: 06.05.2014
(51) Int. Cl.: H01L 23/36, H01L 23/373, H01L 23/538, H01L 23/498

(54) **LEISTUNGSMODUL**
POWER MODULE
MODULE DE PUISSANCE

(30) Priorität: 11.06.2013 AT 503822013
(43) Veröffentlichungstag der Anmeldung: 20.04.2016
(73) Patentinhaber: AT & S Austria Technologie & Systemtechnik Aktiengesellschaft, 8700 Leoben-Hinterberg (AT)
(72) Erfinder: STAHR, Johannes, A-8605 St. Lorenzen (AT); ZLUC, Andreas, A-8700 Leoben (AT); GROBER, Gernot, 8643 Allerheiligen (AT); SCHWARZ, Timo, A-8770 St. Michael i.O. (AT)
(74) Vertreter: Patentanwaltskanzlei Matschnig & Forsthuber OG
(86) Internationale Anmeldenummer: PCT/AT2014/050113
(87) Internationale Veröffentlichungsnummer: WO 2014/197917

(56) Entgegenhaltungen:
- EP-A1- 0 275 433
- GB-A- 2 485 087
- US-B1- 6 442 033
- PANG Y ET AL: "Assessment of Some Integrated Cooling Mechanisms for an Active Integrated Power Electronics Module", JOURNAL OF ELECTRONIC PACKAGING, ASME INTERNATIONAL, US, Bd. 129, Nr. 1, 1. März 2007 (2007-03-01), Seiten 1-8, XP008171355, ISSN: 1043-7398, DOI: 10.1115/1.2429703
- Jian Yin: "High Temperature SiC Embedded Chip Module (ECM) with Double-sided Metallization Structure", , 3. Januar 2006 (2006-01-03), XP055135318, Gefunden im Internet: URL:http://hdl.handle.net/10919/30076
- CHARBONEAU B C ET AL: "Double-Sided Liquid Cooling for Power Semiconductor Devices Using Embedded Power Packaging", IEEE TRANSACTIONS ON INDUSTRY APPLICATIONS, IEEE SERVICE CENTER, PISCATAWAY, NJ, US, Bd. 44, Nr. 5, 1. September 2008 (2008-09-01), Seiten 1645-1655, XP011446042, ISSN: 0093-9994, DOI: 10.1109/TIA.2008.2002270
- MITAL ET AL: "Thermal Design Methodology for an Embedded Power Electronic Module Using Double-Sided Microchannel Cooling", JOURNAL OF ELECTRONIC PACKAGING, ASME INTERNATIONAL, US, Bd. 130, Nr. 3, 1. September 2008 (2008-09-01), Seiten 31003-1, XP008171354, ISSN: 1043-7398, DOI: 10.1115/1.2957320 [gefunden am 2008-07-29]

## Beschreibung

### HINTERGRUND DER ERFINDUNG

### Gegenstand der Erfindung

Die Erfindung bezieht sich auf ein Leistungsmodul, mit einem Leiterplatten-Kern, welcher zumindest eine in eine Isolierschicht eingebettete elektronische Leistungskomponente enthält und der Kern zwischen zwei Wärmeableitplatten angeordnet ist, wobei jede Wärmeableitplatte eine metallische Außenschicht und eine von dieser durch eine wärmeleitende, elektrisch isolierende Zwischenschicht elektrisch getrennte metallische Innenschicht besitzt, und Elektrodenanschlüsse der zumindest einen Leistungskomponente über Anschlussleitungen aus dem Kern geführt sind.

### Stand der Technik

Bei Leistungsmodulen, die beispielsweise IGBTs samt Freilaufdioden beinhalten und welche hohe Ströme und Spannungen verarbeiten sollen, die beispielsweise bei DC/AC-Wandlern im Fahrzeugbereich bei Elektroantrieben im Bereich von 500 Volt und 200 Ampere und auch darüber liegen, besteht die Notwendigkeit, den thermischen Widerstand so gering wie möglich zu halten, wobei die Anschlussleitungen für hohe Ströme bei sehr niedriger Induktivität ausgelegt werden sollen. Derzeit werden beim Aufbau solcher Module vor allem die sogenannte "Wire-Bond"-Technologie mit Al-Drähten und Lötverbindungen verwendet. Die einzelnen Komponenten, wie IGBTs und Dioden, sind dabei auf speziellen Substraten (z.B. DBC = Direct Bond Copper Technology), die beispielsweise aus zwei Kupferschichten bestehen, welche durch eine keramische Schicht, wie Al₂O₃, getrennt sind, angeordnet.

Um den elektrischen und thermischen Anforderungen zu genügen, muss die Führung der Anschlussleitungen komplex gestaltet werden, wobei beispielsweise zum Anschluss oben liegender Gate- und Source-Kontakte von IGBTs dicke Aluminiumdrähte verwendet werden, die allerdings auf Grund ihres hohen thermischen Ausdehnungskoeffizienten dazu neigen, sich abzulösen oder wegen sogenannter "Heel Cracks" an Biegungen einzureißen. Bei solchen Anordnungen werden die Drain-Kontakte eines IGBTs, die an der gegenüberliegenden Seite angeordnet sind, auf das Substrat gelötet oder durch Presssintern verbunden. Dieses Substrat (DCB) ist auf eine dicke Aluminiumplatte gelötet, welche über ein wärmeleitendes Interface Material an einer Wärmeableitplatte angeordnet ist. Es hat sich jedoch gezeigt, dass im längeren Betrieb Fehler auftreten, die auf Zyklen der Leistungs-und Wärmebeanspruchung und daraus entstehenden unterschiedlichen Ausdehnungen der Komponenten und Rissen und Materialermüdung zurückzuführen sind und sich z.B. in einem Ablösen der Aluminiumdrähte oder in Brüchen des Chips oder Substrats manifestieren.

Die bisher bevorzugt verwendeten Einbettungen von Leistungshalbleitern sind auch durch eine hohe Selbstinduktivität der Drahtverbindungen gekennzeichnet, die zu Leistungsverlusten und hoher Erwärmung führt, sowie durch die Verwendung teurer Substrate für die elektrische Isolierung und Wärmeüberleitung. Um die Effizienz der Kühlung zu verbessern, sind auch Lösungen geschaffen worden, die eine doppelseitige Kühlung vorsehen. Beispiele solcher bekannter Leistungsmodule sind unter anderem in der US 8,102,047 B2, der US 7,514,636 B2 oder der US 8,358,000 B2 gezeigt und beschrieben. Weiters sind aus den beiden Dokumenten Pang Y. et al: "Assessment of Some Integrated Cooling Mechanisms for an Active Integrated Power Electronics Module" (Journal of Electronic Packaging, ASME International, Vol. 129, März 2007, Seiten 1-8; XP008171355; ISSN: 1043-7398; DOI: 10.1115/1.2429703) sowie Jian Yin: "High Temperature SiC Embedded Chip Module (ECM) with Double-sided Metallization Structure" (Dissertation, Dezember 2005, Virginia Polytechnic Institute and State University; XP055135318), unterschiedliche Ausführungsformen von Leistungsmodulen bekannt.

Ein Leistungsmodul der eingangs genannten Art ist beispielsweise aus dem Artikel "High Power IGBT Modules Using Flip Chip Technology", IEEE Transactions on Components and Packaging Technology, Vol. 24, No. 4, December 2001, bekannt geworden. Bei diesem Modul ist ebenfalls eine beidseitige Kühlung vorgesehen, wobei Leistungskomponenten, hier zwei IGBTs und vier Dioden, zwischen zwei DBC-Schichten eingebettet sind, die ihrerseits auf Kühlkörpern aufgelötet sind. Das DBC-Substrat der beiden Schichten besteht aus einer 0,63 mm dicken Al₂O₃-Schicht, die beidseitig mit 0,3 mm starken Kupferschichten belegt ist. Der Drain-Kontakt der IGBTs und die Kathodenanschlüsse der Dioden sind mit einem Zinn/Blei/Silber-Lot an die untere DBC-Schicht gelötet, die Source- und die Gate-Kontakte der IGBTs und die Anodenkontakte der Dioden sind mit demselben Lot an die obere DBC-Schicht gelötet, wobei eine Flip-Chip-Bondtechnik zur Anwendung kommt.Die Anschlussleitungen zu den Source- und die Gate-Kontakten der IGBTs und den Anodenkontakten der Dioden werden in der strukturierten dünnen inneren Kupferschicht der oberen DBC-Schicht geführt. Wenngleich hier eine doppelseitige Kühlung angewendet wird, bleibt die Problematik der Hochstromleitungen zu den Leistungsanschlüssen (Source der IGBTs, Anoden der Dioden), vor allem mit Blick auf die Eigeninduktivitäten ungelöst.

An dieser Stelle sei angemerkt, dass sich die Begriffe "oben" und "unten" auf die üblicherweise verwendeten Darstellungen beziehen, aber nichts über die tatsächliche Gebrauchslage der Module aussagen. Weiters sind die hier in Frage kommenden Leistungskomponenten zwar in erster Linie Leistungshalbleiter, wie IGBTs und Freilaufdioden, doch soll dies keine Einschränkung bedeuten, da auch andere aktive oder passive elektronische/elektrische Komponenten Teil des Moduls sein können.

Eine Aufgabe der Erfindung besteht in der Schaffung eines Leistungsmoduls der gegenständlichen Art, bei welchem auf kostengünstige Weise dem Problem der Wärmeableitung bzw. Wärmeerzeugung durch Leitungsinduktivitäten bei in einem Modul eingebetteten Leistungskomponenten begegnet wird.

### ZUSAMMENFASSUNG DER ERFINDUNG

Ausgehend von einem Leistungsmodul der eingangs genannten Art löst die Erfindung die gestellten Aufgaben dadurch, dass der Leiterplatten-Kern an beiden Seiten der Isolierschicht eine Leiterschicht besitzt, zumindest eine Leiterschicht zumindest abschnittsweise strukturiert ist und jede Leiterschicht zumindest abschnittsweise über eine leitende, metallische Zwischenlage mit einer metallischen Innenschicht der Wärmeableitplatte verbunden ist, von der strukturierte Leiterschicht ausgehend Durchkontaktierungen zu den Elektrodenanschlüssen der zumindest einen Leistungskomponente verlaufen und zumindest ein Leistungsanschluss der zumindest einen Leistungskomponente über eine Durchkontaktierung, einen Abschnitt der strukturierten Leiterschicht und die leitende, metallische Zwischenlage mit zumindest einem Abschnitt der metallischen Innenschicht der Wärmeableitplatte verbunden ist, welche einen Teil der Anschlussleitung zu dem Elektrodenanschluss bildet, wobei zumindest die metallischen Innenschichten der Wärmeleitplatten aus Kupfer bestehen und die Isolierschicht des Leiterplatten-Kerns sowie Isoliermaterial zum Ausfüllen oder Abdecken von Zwischenräumen der Leiterstrukturen aus demselben isolierenden Material bestehen.

Leistungsmodule nach der Erfindung können hohe Ströme und Leistungen verarbeiten, wobei sie sich durch geringes Gewicht und geringe Abmessung auszeichnen. Ein wichtiges Einsatzgebiet sind z.B. Spannungswandler in Elektrofahrzeugen, nämlich sowohl in Hybridfahrzeugen als auch in reinen Elektrofahrzeugen.

Es ist vorteilhaft, dass zumindest die metallischen Innenschichten der Wärmeleitplatten aus Kupfer bestehen, da in Hinblick auf die Ausbildung von Leiterbahnen und seine Wärmeleitfähigkeit Kupfer ein bewährtes Material ist.

Eine zweckmäßig herstellbare elektrische Verbindung erhält man, wenn zumindest ein Anschluss einer Leistungskomponente über eine Leiterschicht und eine leitende metallische Zwischenlage mit der metallischen Innenschicht einer Wärmeableitplatte verbunden ist.

Insbesondere zum Ausgleich ungleicher Höhen der Komponenten ist es empfehlenswert, wenn zumindest ein Anschluss einer Leistungskomponente über einen strom- und wärmeleitenden Metallblock mit einer Leiterschicht verbunden ist. Dabei ist es fertigungstechnisch von Vorteil, wenn ein Anschluss mit einer Leiterschicht über eine metallische Zwischenlage verbunden ist.

Im Sinne einer Verbesserung der thermischen und elektrischen Belastbarkeit kann vorgesehen sein, dass der Leiterplatten-Kern zumindest einen Metallblock aufweist, der zumindest mit Abschnitten der oberen und unteren Leiterschicht in thermischer und/oder elektrischer Verbindung steht. Dabei ist es empfehlenswert, wenn der zumindest eine Metallblock aus Kupfer besteht.

Eine vorteilhafte Entflechtung von Leistungs- und Steuerleitungen ergibt sich, wenn das Modul zumindest einen IGBT-Chip/MOSFET enthält, dessen Source- und Drain-Anschlüsse mit der metallischen Innenschicht in Verbindung stehen, wogegen der Gate-Anschluss über eine Leiterbahn aus dem Modul geführt ist.

Bei einer vorteilhaften Weiterbildung des Leistungsmoduls nach der Erfindung ist vorgesehen, dass es zumindest eine Leistungsdiode enthält, deren Kathode bzw. Anode mit der metallischen Innenschicht in Verbindung stehen.

Bei einer zweckmäßigen Weiterbildung der Erfindung ist vorgesehen, dass die metallische Zwischenlage aus einem Niedrigtemperatur-Silber-Sintermaterial besteht.

### KURZE BESCHREIBUNG DER ZEICHNUNGEN

Die Erfindung samt weiteren Vorteilen ist im Folgenden an Hand beispielsweise Ausführungsformen näher erläutert, die in der Zeichnung veranschaulicht sind. In dieser zeigen
Fig. 1 einen Schnitt durch eine erste Ausführungsform der Erfindung,
Fig. 2 einen Schnitt durch einen Leiterplatten-Kern einer zweiten Ausführung,
Fig. 3 einen Schnitt durch einen Leiterplatten-Kern einer dritten Ausführung,
Fig. 4 einen Schnitt durch einen Leiterplatten-Kern einer vierten Ausführung,
Fig. 5a bis g einzelne Schritte eines bevorzugten Verfahrens zur Herstellung eines Leistungsmoduls nach der Erfindung, und
Fig. 6a bis e einzelne Schritte eines anderen bevorzugten Verfahrens zur Herstellung eines Leiterplatten-Kerns für ein Leistungsmodul nach der Erfindung

### BESCHREIBUNG BEVORZUGTER AUSFÜHRUNGSFORMEN

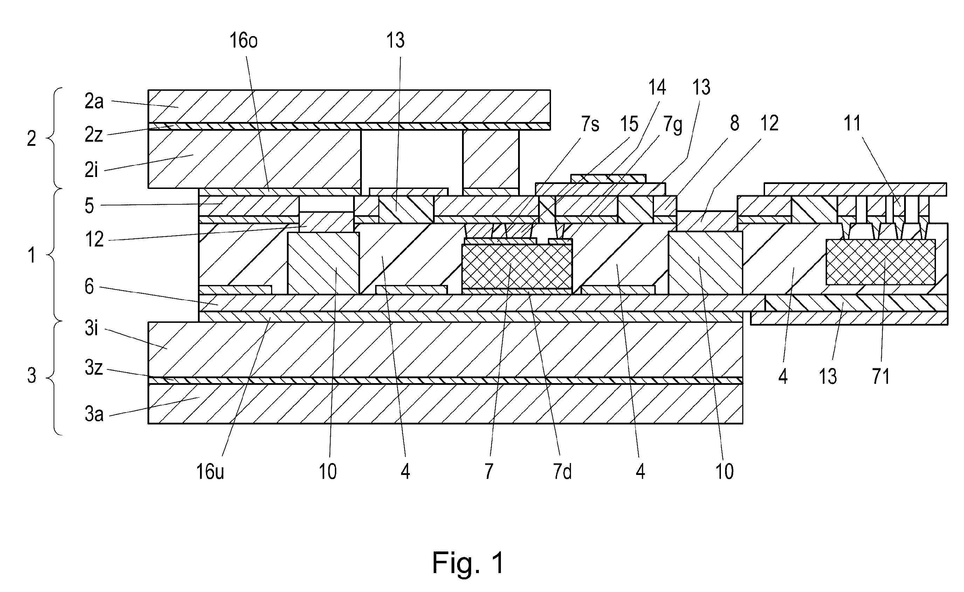

Fig. 1 zeigt zum Teil schematisch eine erste Ausführung eines Leistungsmoduls nach der Erfindung, welches einen Leiterplatten-Kern 1 aufweist, der zwischen zwei Wärmeableitplatten 2 und 3 angeordnet ist. Der Leiterplatten-Kern 1 besteht wie eine übliche zweiseitige Leiterplatte aus einer Isolierschicht 4, beispielsweise einem im Leiterplattenbau üblichen Prepreg, das an beiden Seiten eine Leiterschicht, nämlich eine Kupferschicht besitzt. Hier ist die obere Leiterschicht 5 unter Bildung von Leiterbahnen 8 strukturiert, die untere Leiterschicht 6 müsste im vorliegenden Beispiel nicht notwendigerweise strukturiert sein. In die Isolierschicht 4 sind im vorliegenden Fall ein IGBT-Chip 7, ein IGBT-Treiber 71 und zwei Kupfereinlagen 10 eingebettet.

Der IGBT-Chip 7 besitzt drei Elektrodenanschlüsse, nämlich einen unteren Drain-Anschluss 7d, einen oberen Source-Anschluss 7s sowie einen oberen Gate-Anschluss 7g. Die Anschlüsse des IGBT-Chips 7 sind mit Vorteil Kupfer-metallisiert, wobei der Drain-Anschluss 7d mit der unteren Leiterschicht 6 in Verbindung gebracht ist. Diese Verbindung kann entweder direkt (Kupfer-Kupfer) erfolgen oder unter Verwendung eines Lots oder eines Sintermaterials. Von der oberen Leiterschicht 5 verlaufen allgemein mit dem Bezugszeichen 11 bezeichnete Kontaktierungen zu dem Source-Anschluss 7s bzw. zu dem Gate-Anschluss 7g. Es ist ersichtlich, dass die Verbindungen zu den Leistungsanschlüssen (Drain, Source) insgesamt einen wesentlich größeren Querschnitt aufweisen, als die Verbindung zu dem Steueranschluss (Gate). Um Missverständnisse zu vermeiden, möge an dieser Stelle darauf hingewiesen werden, dass vor allem im deutschen Sprachraum Source und Drain eines IGBT-Transistors oft mit Kollektor und Emitter bezeichnet werden.

Die nicht näher bezeichneten Ein- und Ausgänge des IGBT-Treibers 71 stehen ebenfalls über Kontaktierungen 11, beispielsweise aus galvanisch aufgebrachtem Kupfer, mit den Strukturen der oberen Leiterschicht 5 in Verbindung. Die erwähnten Kupfereinlagen 10, welche einerseits als Durchkontaktierungen zur elektrischen Verbindung der oberen Leiterschicht 5 mit der unteren Leiterschicht 6 und andererseits zur Verbesserung der Wärmeableitung und der Erhöhung der Wärmekapazität dienen, sitzen in diesem Beispiel mit ihrer Unterseite auf der unteren Leiterschicht 6 und sind über Kupferkontaktierungen 12 gleichfalls mit der oberen Leiterschicht 5 in Kontakt gebracht.

Zwischenräume der Leiterstrukturen können sowohl an der oberen als auch an der unteren Leiterschicht 5 bzw. 6 mit Isoliermaterial 13, wie z.B. einem Prepreg, ausgefüllt oder abgedeckt sein, nicht zuletzt, um die Gefahr von Spannungsdurchschlägen oder Kriechströmen zu bannen. Auf Lagen dieses Isoliermaterials können wieder Kontakte oder Leiterzüge angeordnet sein, wie die Leiterbahn 14, zu welcher über eine Kontaktierung 15 der Gate-Anschluss 7g geführt ist.

Der soeben beschriebene Leiterplatten-Kern 1 steht mit den Wärmeableitplatten 2 und 3 in thermischer bzw. elektrischer Verbindung, was nachstehend erläutert wird. Jede der Wärmeableitplatten 2, 3 besitzt eine metallische Außenschicht 2a, 3a und eine von dieser durch eine wärmeleitende, elektrisch isolierende Zwischenschicht 2z, 3z elektrisch getrennte metallische Innenschicht 2i, 3i. Bei derartigen Wärmeableitplatten, die auch unter der Bezeichnung IMS (Insulated Metal Substrate) bekannt sind, besteht beispielsweise die metallische Innenschicht 2i, 3i aus Kupfer mit einer Stärke von 200 bis 400 µm, die metallische Außenschicht 2a, 3a aus Aluminium oder Kupfer mit einer Stärke von 1 bis 2 mm und die isolierende Zwischenschicht 2z, 3z aus einem Polymermaterial mit einem hohen Füllgrad von Partikeln aus Aluminiumoxid oder Aluminiumnitrid mit einer Stärke von 100 µm. Die metallische Außenschicht 2a, 3a, kann auch mit Kanälen oder Strukturierungen für eine forcierte Gas- oder Flüssigkeitskühlung versehen sein. Es versteht sich, dass die Stärken der einzelnen Schichten abhängig von der jeweiligen Anwendung und thermischer Belastung in weiten Grenzen gewählt werden können.

Die Verbindung des Leiterplatten-Kerns 1 mit den Wärmeableitplatten 2 und 3 erfolgt je über eine metallische Zwischenlage 16o bzw. 16u, die im vorliegenden Fall aus einem Niedrigtemperatur-Silber-Sintermaterial besteht. Wie Fig. 1 entnommen werden kann, ist der Drain-Anschluss 7d des IGBT-Chips 7 über die untere Leiterschicht 6 und die Zwischenlage 16u flächig und auf kürzestem Weg mit der metallischen Innenschicht 3i der unteren Wärmeableitplatte 3 verbunden. Sinngemäß gleiches gilt für den Source-Anschluss 7s, der gleichfalls auf kürzestem Weg mit einem Abschnitt der metallischen Innenschicht 2i verbunden ist. Solchermaßen können die hohen, über Source und Drain fließenden Ströme direkt in die dicken Kupferlagen der Wärmeableitplatten eingeleitet werden, ohne dass sie über Leitungen mit höherer Selbstinduktivität fließen müssen, und auch die in dem IGBT-Chip erzeugte Wärme wird auf kürzestem Weg über die Wärmeableitplatten 2 und 3 abgezogen. Günstig sind die hohe Wärmeleitfähigkeit (typisch 150 bis 250 W/mK) sowie die hohe mechanische Festigkeit der Verbindung aus Silber-Sintermaterial.

Andere Anschlüsse von eingebetteten Komponenten, über welche keine hohen Ströme fließen müssen, können über entsprechende Kontaktierungen mit Leiterstrukturen der oberen bzw. unteren Leiterschicht 5 bzw. 6 verbunden werden und in bekannter Weise über Leiterbahnen dieser Schichten 5 und 6 seitlich herausgeführt werden. Dies trifft bei diesem Beispiel für den Gate-Anschluss 7g des IGBTs 7 und für die Anschlüsse des IGBT-Treibers 71 zu. Dies bedeutet aber nicht, dass prinzipiell nur Hochstromleitungen über die inneren Schichten 2i, 3i aus Kupfer aus dem Modul geführt werden können. Gegebenenfalls kann dies auch für Steuerleitungen oder andere Leitungen zutreffen.

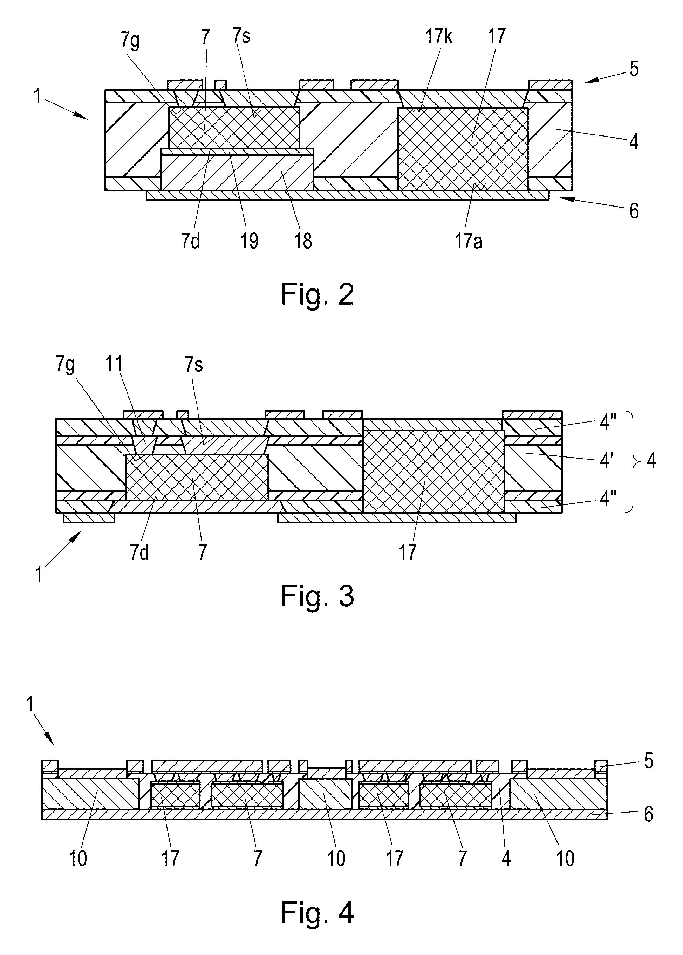

Fig. 2, in welcher für gleiche oder vergleichbare Teile gleiche Bezugszeichen wie in Fig. 1 verwendet werden, zeigt ein anderes Beispiel für den Aufbau eines Leiterplatten-Kerns 1. In diesem ist außer einem IGBT-Chip 7 auch eine Leistungsdiode 17 in die Prepreg-Isolierschicht 4 eingebettet. Derzeit beträgt die Dicke handelsüblicher IGBTs typisch 70 bis 150 µm, jene von Dioden jedoch typisch 300 µm. Es wird zwar angestrebt, auch Dioden mit annähernd gleicher Dicke wie IGBTs einzusetzen, doch muss, falls dies nicht möglich ist, ein Dickenausgleich geschaffen werden. Eine Möglichkeit hierzu ist in Fig. 2 gezeigt, bei welcher ein Metallblock 18, hier aus Kupfer, mittels einer metallischen Zwischenlage 18, hier einer Silber-Sinterpaste 19, mit dem IGBT-Chip 7 leitend verbunden und somit die Dicke des IGBT-Chips samt Kupferblock an die Dicke der Diode angepasst ist. Aus Fig. 2 geht hervor, dass nach Aufbringen der hier nicht gezeigten Wärmeableitplatten auch die beiden Anschlüsse der Leistungsdiode 17, nämlich ihr Anodenanschluss 17a und ihr Kathodenanschluss 17k, auf kürzestem Weg mit den leitenden Innenschichten der Wärmeableitplatten verbunden werden können ebenso wie dies in Fig. 1 in Zusammenhang mit den Leistungsanschlüssen des IGBT-Chips 7 gezeigt ist. Der Kupferblock 18 dient zwar hier in erster Linie zur Anpassung an die unterschiedlichen Dicken der Komponenten, doch bietet er daneben durch seine hohe Wärmekapazität den Vorteil, dass impulsartig, z.B. im Kurzschlussfall, auftretende Verlustwärme rasch aufgenommen und vorübergehend gespeichert werden kann.

Eine andere Möglichkeit, die unterschiedliche Dicke von Komponenten auszugleichen, wird im Folgenden an Hand der Fig. 3 erläutert. Hier werden zwei Laminierungsschritte vorgenommen: Zunächst wird die dünnere Komponente, hier der IGBTChip 7, in der Mitte des Kerns 1 festgelegt und die elektrischen Verbindungen werden durch Verkupfern hergestellt. Darnach erfolgt der zweite Laminierschritt und es werden Öffnungen durch Laserschneiden hergestellt, um das Aufbringen einer dicken Kupferschicht auf die Ober- bzw. Unterseite der Leistungskomponenten zu ermöglichen. Die erste Isolierschicht 4' bildet mit den im zweiten Laminierschritt hergestellten zweiten Isolierschichten 4" die gesamte Isolierschicht 4. Besonders bei den Verbindungen zum Gate-Anschluss 7g und zum Source-Anschluss 7s erkennt man deutlich den zweistufigen Aufbau der Kontaktierungen 11. Die dickere Komponente, hier wieder eine Leistungsdiode 17, kann dann auch in den Leiterplatten-Kern 1 eingebettet werden. Wichtig ist es, die dünnere Komponente - den IGBT-Chip 7 - in die Mitte des Kerns 1 zu bringen, um die Tiefe der Kavitäten in Hinblick auf das Verkupfern möglichst gering zu halten und dadurch den Verbindungsvorgang mit den Wärmeableitplatten 2, 3 nicht durch zu tiefe Kavitäten zu erschweren. Das zweistufige Laminieren wäre in Hinblick auf den Höhenunterschied zwar nur an der Oberseite erforderlich, doch empfiehlt es sich im Sinne der Aufrechterhaltung einer weitgehenden Symmetrie auch an der Unterseite ein zweites Laminieren vorzunehmen.

Fig. 4 stellt eine weitere Variante eines Leiterplatten-Kerns 1 dar, bei welcher zwei IGBT-Chips 7 und zwei Leistungsdioden 17 für eine Halbbrückenschaltung in die Isolierschicht 4 eingebettet sind. Außerdem sind drei Kupfereinlagen 10 zur Verbesserung der thermischen Eigenschaften vorgesehen. Der Aufbau zu einem fertigen Leistungsmodul sinngemäß entsprechend jenem nach Fig. 1 erfolgt dann durch allfälliges Aufbringen von Isoliermaterial 13 (siehe Fig. 1) und Verbinden der oberen und unteren Leiterschichten mit den metallischen Innenschichten 2i, 3i der Wärmeableitplatten 2, 3. Wie in Fig. 1 kann auch hier in dem Leiterplatten-Kern 1 noch ein IGBT-Treiber, wie der Treiber 71 der Fig. 1, eingebettet sein.

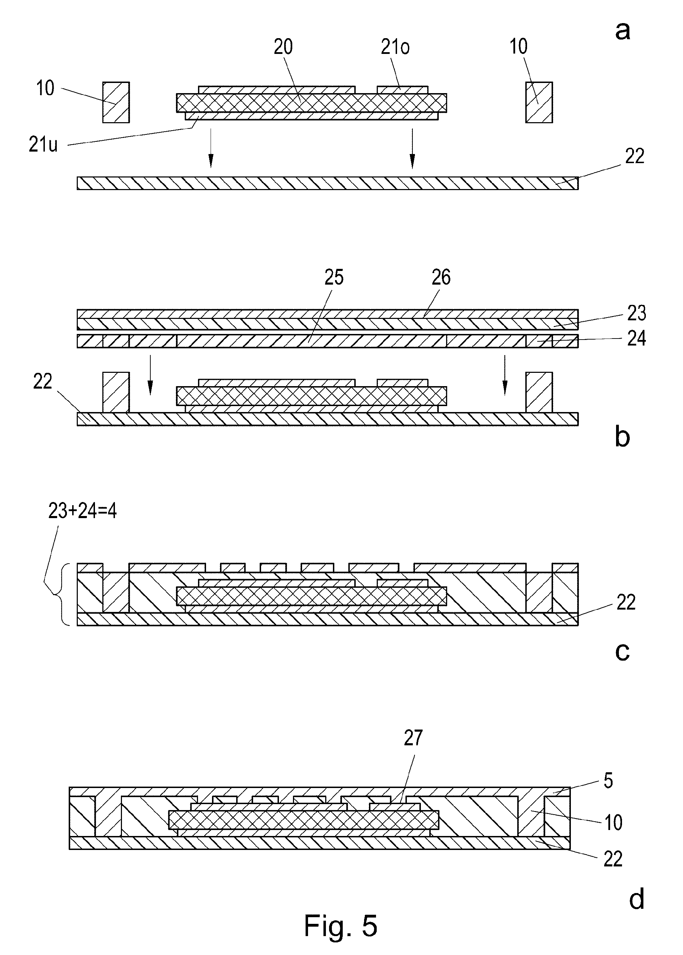

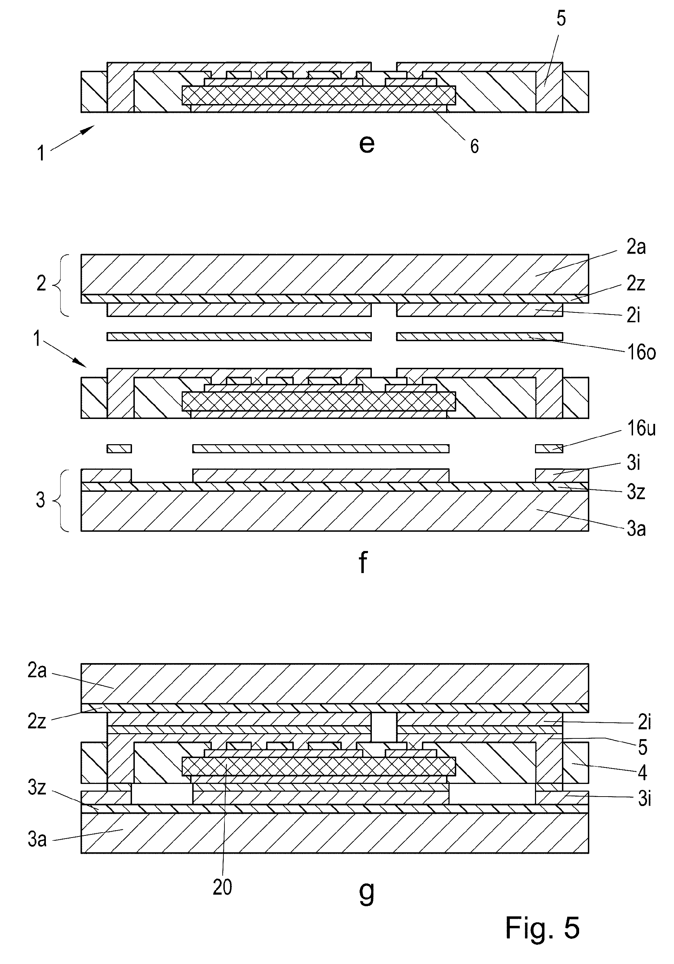

Ein bevorzugtes Verfahren zur Herstellung eines Leistungsmoduls nach der Erfindung wird nun an Hand der Fig. 5 in einzelnen wichtigen Schritten erläutert.

In Fig. 5a erkennt man einen Leistungshalbleiter 20, beispielsweise einen IGBT-Chip, dessen Anschlüsse eine obere und eine untere Kupfermetallisierung 21o und 21u aufweisen. Der Leistungshalbleiter 20 wird zusammen mit zwei Kupfereinlagen 10 auf eine selbstklebende Trägerfolie aufgesetzt, was durch zwei Pfeile angedeutet ist. Auf diesen Aufbau wird nun gemäß Fig. 5b eine Prepreg-Lage 23 mit den Leistungshalbleiter 20 und die Kupfereinlagen 10 berücksichtigenden Ausschnitten 24 und darüber eine weitere Prepreg-Lage 25 mit einer oberen Kupferfolie 26 aufgebracht. Nun erfolgt eine Bohr- bzw. Laserbearbeitung zur Herstellung von Ausschnitten in der Kupferfolie 26 bzw. in der Prepreg-Lage 23, deren Ergebnis in Fig. 5c dargestellt ist.

Als nächstes erfolgen ein galvanisches Kontaktieren mit Kupfer und eine Verstärkung der Kupferfolie 26, sodass dann, wie in Fig. 5d zu sehen, Kontaktierungen 27 zu dem Leistungshalbleiter 20 und den Kupfereinlagen 10 hergestellt sind. Vor der galvanischen Kontaktierung kann die Trägerfolie 22 abgezogen werden, falls, z.B gemäß Fig 1 bis 4, eine beidseitige Kupferplattierung erwünscht ist. Die obere verstärkte Leiterschicht ist nun mit dem Bezugszeichen 5 versehen, da sie der oberen Leiterschicht 5 der Fig. 1 bis 4 entspricht. In einem nächsten Schritt erfolgt ein Strukturieren dieser Leiterschicht 5, wobei zuvor oder darnach die Trägerfolie 22 entfernt wird. Nun liegt ein fertiger Leiterplatten-Kern 1 vor, wobei die untere Kupfermetallisierung 21u zusammen mit den Unterflächen der Kupfereinlagen 10 der unteren Leiterschicht 6 der Fig. 1 bis 4 entspricht und entsprechend bezeichnet sind.

Wie in Fig. 5f gezeigt, erfolgt in einem nächsten Schritt der Zusammenbau zu dem Leistungsmodul durch Anfügen einer oberen und einer unteren Wärmeableitplatte 2 und 3. Wie bereits weiter oben erläutert, besteht jede Wärmeableitplatte 2, 3 aus einer metallischen Außenschicht 2a, 3a aus Aluminium, aus einer isolierenden Zwischenschicht 2z, 3z und einer metallischen strukturierten Innenschicht 2i, 3i aus Kupfer. Das Sintern erfolgt unter Anwendung von Druck und Wärme und unter Verwenden einer Silbersinterpaste 16o, 16u entsprechend den metallische Zwischenlagen 16o bzw. 16u der Fig. 1. Als Ergebnis erhält man das fertige Leistungsmodul entsprechend Fig. 5g.

Zwar ist in Fig. 5 nur eine einzige eingebettete Komponente gezeigt, doch sollte es klar sein, dass mehrere Leistungskomponenten und andere Bauteile, wie Treiberchips etc. nach dem gezeigten Verfahren eingebettet werden können und dann in dem fertigen Modul enthalten sind.

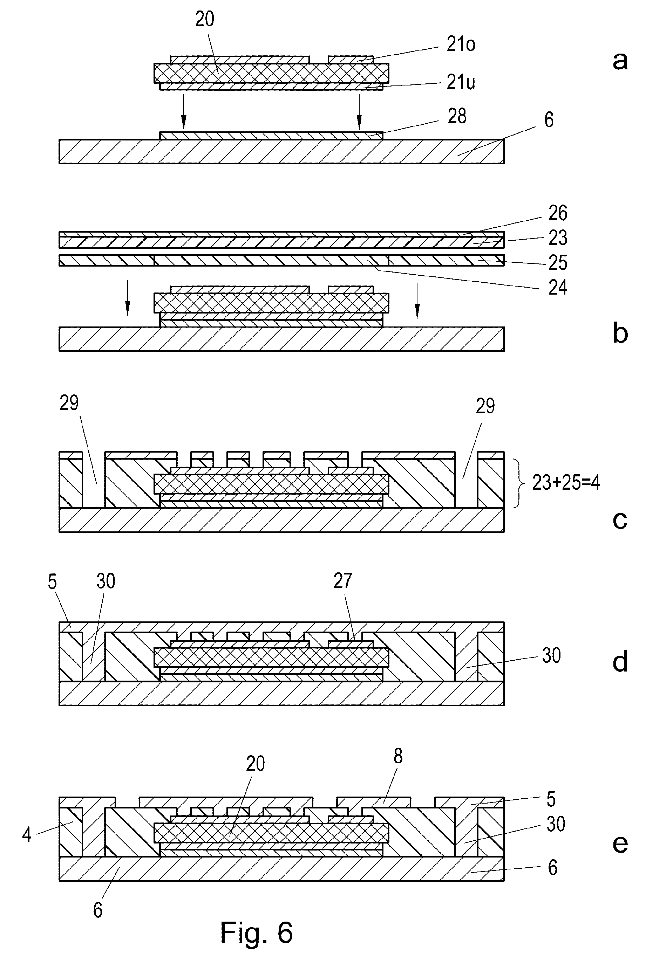

Die nun an Hand der Fig. 6 beschriebene Variante eines Herstellungsverfahrens ist dem zuvor beschriebenen weitgehend ähnlich, doch wird hier zur Verbesserung der Wärmeableitung der Leistungshalbleiter 20 mit den oberen und unteren Kupfermetallisierungen 21o und 21u mit seiner Unterseite auf einen Kupferträger als untere Leiterschicht 6 aufgebracht, auf den zuvor eine Silber-Sinterpaste 28 aufgebracht wurde (Fig. 6a). Daraufhin wird wie beim zuvor beschriebenen Verfahren eine Prepreg-Lage 23 mit einem Ausschnitt 24 für den Leistungshalbleiter 20 und darüber eine weitere Prepreg-Lage 25 mit einer oberen Kupferfolie 26 aufgebracht. Es sei angemerkt, dass bei diesem und dem zuvor beschriebenen Verfahren die Anzahl der Prepreg-Lagen je nach Bauteildicke und/oder Verfügbarkeit der Prepreg-Dicken variieren kann.

Nach dem Laminierungsschritt erfolgt im folgenden Schritt gemäß der Darstellung der Fig. 6c eine Bohr- bzw. Laserbearbeitung zur Herstellung von Ausschnitten in der Kupferfolie 26 bzw. in den Prepreg-Lagen 23 und 25, wobei in diesem Fall im Gegensatz zu dem vorhin beschriebenen Verfahren auch zwei bis zu der unteren Leiterschicht 6 durchgehende Ausschnitte 29 hergestellt werden.

Im Weiteren erfolgt ein galvanisches Kontaktieren mit Kupfer zu den oberen Anschlüssen des Leistungshalbleiters 20 und es werden auch galvanisch Durchkontaktierungen 30 von der oberen Kupferfolie 26 zu der unteren Leiterschicht 6 hergestellt.

Auch hier wird die Kupferfolie 26 galvanisch verstärkt, wobei die obere verstärkte Leiterschicht nun mit dem Bezugszeichen 5 versehen ist, da sie der oberen Leiterschicht 5 der Fig. 1 bis 4 entspricht (Fig. 6d). Es erfolgt darnach ein Strukturieren dieser Leiterschicht 5, sodass Leiterbahnen 8 entstehen und es liegt wiederum ein fertiger Leiterplatten-Kern 1 vor (Fig. 6e), der sodann, sinngemäß entsprechend Fig. 5f und 5g zu einem Leistungsmodul durch Anfügen einer oberen und einer unteren Wärmeleitplatte zusammengebaut wird.

## Patentansprüche

1. Leistungsmodul, mit einem Leiterplatten-Kern (1), welcher zumindest eine in eine Isolierschicht (4) eingebettete elektronische Leistungskomponente (7, 17, 20) enthält und der Kern zwischen zwei Wärmeableitplatten (2, 3) angeordnet ist, wobei jede Wärmeableitplatte eine metallische Außenschicht (2a, 3a) und eine von dieser durch eine wärmeleitende, elektrisch isolierende Zwischenschicht (2z, 3z) elektrisch getrennte metallische Innenschicht (2i, 3i) besitzt, und Elektrodenanschlüsse der zumindest einen Leistungskomponente über Anschlussleitungen aus dem Kern geführt sind,
und zumindest ein Leistungsanschluss (7s) der zumindest einen Leistungskomponente (7) über eine Kontaktierung (11), einen Abschnitt einer strukturierten Leiterschicht (5) und eine leitende, metallische Zwischenlage (16o) mit zumindest einem Abschnitt der metallischen Innenschicht (2i) der Wärmeableitplatte verbunden ist, welche einen Teil der Anschlussleitung zu dem Elektrodenanschluss bildet, wobei zumindest die metallischen Innenschichten (2i, 3i) der Wärmeableitplatten (2, 3) aus Kupfer bestehen,
**dadurch gekennzeichnet, dass**
der Leiterplatten-Kern (1) an beiden Seiten der Isolierschicht (4) eine Leiterschicht (5, 6) besitzt, zumindest eine Leiterschicht (5) zumindest abschnittsweise strukturiert ist und jede Leiterschicht (5, 6) zumindest abschnittsweise über eine leitende, metallische Zwischenlage (16o, 16u) mit einer metallischen Innenschicht (2i, 3i) der Wärmeableitplatte (2, 3) verbunden ist, von der strukturierten Leiterschicht ausgehend Kontaktierungen (11) zu den Elektrodenanschlüssen der zumindest einen Leistungskomponente (7, 17, 20) verlaufen und die Isolierschicht (4) des Leiterplatten-Kerns (1) sowie Isoliermaterial (13) zum Ausfüllen oder Abdecken von Zwischenräumen der Leiterstrukturen aus demselben isolierenden Material bestehen.

2. Leistungsmodul nach Anspruch 1, **dadurch gekennzeichnet, dass** zumindest ein Anschluss (7d) einer Leistungskomponente (7) über eine Leiterschicht (6) und eine leitende metallische Zwischenlage (16u) mit der metallischen Innenschicht (3i) einer Wärmeableitplatte (3) verbunden ist.

3. Leistungsmodul nach Anspruch 1 oder 2, **dadurch gekennzeichnet, dass** zumindest ein Anschluss (7d) einer Leistungskomponente (7) über einen strom- und wärmeleitenden Metallblock (18) mit einer Leiterschicht (6) verbunden ist.

4. Leistungsmodul nach Anspruch 3, **dadurch gekennzeichnet, dass** ein Anschluss (7d) mit einer Leiterschicht (6) über eine metallische Zwischenlage (19) verbunden ist.

5. Leistungsmodul nach einem der Ansprüche 1 bis 4, **dadurch gekennzeichnet, dass** die metallischen Zwischenlagen (16o, 16u; 19) aus einem Niedrigtemperatur-Silber-Sintermaterial besteht.

6. Leistungsmodul nach einem der Ansprüche 1 bis 5, **dadurch gekennzeichnet, dass** der Leiterplatten-Kern (1) zumindest einen Metallblock (10) aufweist, der zumindest mit Abschnitten der oberen und unteren Leiterschicht (5, 6) in thermischer und/oder elektrischer Verbindung steht.

7. Leistungsmodul nach Anspruch 6, **dadurch gekennzeichnet, dass** der zumindest eine Metallblock (10) aus Kupfer besteht.

8. Leistungsmodul nach einem der Ansprüche 1 bis 7, **dadurch gekennzeichnet, dass** es zumindest einen IGBT-Chip/MOSFET (7) enthält, dessen Source- und Drain- Anschlüsse (7s, 7d) mit der metallischen Innenschicht (2i, 3i) in Verbindung stehen, wogegen der Gate-Anschluss (7g) über eine Leiterbahn (14) aus dem Modul geführt ist.

9. Leistungsmodul nach einem der Ansprüche 1 bis 8, **dadurch gekennzeichnet, dass** es zumindest eine Leistungsdiode (17) enthält, deren Kathode bzw. Anode (17k, 17a) mit der metallischen Innenschicht (2i bzw. 3i) in Verbindung stehen.

## Claims

1. A power module, comprising a printed circuit board core (1), which contains at least one electronic power component (7, 17, 20) embedded in an insulating layer (4), the core being arranged between two heat dissipation plates (2, 3), wherein each heat dissipation plate has a metal exterior layer (2a, 3a) and a metal interior layer (2i, 3i) electrically isolated from the metal exterior layer by a heat-conducting, electrically insulating intermediate layer (2z, 3z), and electrode terminals of the at least one power component are guided out of the core via terminal lines, and at least one power terminal (7s) of the at least one power component (7) is connected via a contact-making means (11), a portion of a structured conductor layer (5) and a conductive, metal intermediate ply (16o) to at least a portion of the metal interior layer (2i) of the heat dissipation plate, which forms part of the terminal line to the electrode terminal, wherein at least the metal interior layers (2i, 3i) of the heat dissipation plates (2, 3) consist of copper, **characterised in that** the printed circuit board core (1) has a conductor layer (5, 6) on both sides of the insulating layer (4), at least one conductor layer (5) is structured at least in portions, and each conductor layer (5, 6) is connected, at least in portions, to a metal interior layer (2i, 3i) of the heat dissipation plate (2, 3) via a conductive, metal intermediate ply (16o, 16u), contact-making means (11) run from the structured conductor layer to the electrode terminals of the at least one power component (7, 17, 20), and the insulating layer (4) of the printed circuit board core (1) and insulating material (13) for filling or covering intermediate spaces of the conductor structures are made of the same insulating material.

2. The power module according to claim 1, **characterised in that** at least one terminal (7d) of a power component (7) is connected to the metal interior layer (3i) of a heat dissipation plate (3) via a conductor layer (6) and a conductive metal intermediate ply (16u).

3. The power module according to claim 1 or 2, **characterised in that** at least one terminal (7d) of a power component (7) is connected to a conductor layer (6) via a current- and heat-conducting metal block (18).

4. The power module according to claim 3, **characterised in that** a terminal (7d) is connected to a conductor layer (6) via a metal intermediate ply (19).

5. The power module according to any one of claims 1 to 4, **characterised in that** the metal intermediate plies (16o, 16u; 19) are made of a low-temperature silver sinter material.

6. The power module according to any one of claims 1 to 5, **characterised in that** the printed circuit board core (1) comprises at least one metal block (10), which is thermally and/or electrically connected to at least portions of the upper and lower conductor layers (5, 6).

7. The power module according to claim 6, **characterised in that** the at least one metal block (10) is made copper.

8. The power module according to any one of claims 1 to 7, **characterised in that** it contains at least one IGBT chip/MOSFET (7), the source and drain terminals of which (7s, 7d) are connected to the metal interior layer (2i, 3i), whereas the gate terminal (7g) is guided out of the module via a conductor track (14).

9. The power module according to any one of claims 1 to 8, **characterised in that** it comprises at least one power diode (17), the cathode and/or anode of which (17k, 17a) are connected to the metal interior layer (2i or 3i).

## Revendications

1. Module de puissance, ayant un coeur de carte de circuits imprimés (1), lequel contient au moins un composant de puissance électronique (7, 17, 20) intégré dans une couche isolante (4) et le coeur est agencé entre deux plaques de dissipation thermique (2, 3), chaque plaque de dissipation thermique ayant une couche externe métallique (2a, 3a) et une couche interne métallique (2i, 3i) isolée électriquement de celle-ci par une couche intermédiaire isolante électriquement, conductrice de la chaleur (2z, 3z), et des connexions d'électrode de l'au moins un composant de puissance sont guidées hors du coeur par l'intermédiaire de lignes de connexion, et au moins une connexion de puissance (7s) de l'au moins un composant de puissance (7) est reliée, par l'intermédiaire d'un contact (11), d'une section d'une couche conductrice structurée (5) et d'un revêtement intermédiaire métallique conducteur (16o), à au moins une section de la couche interne métallique (2i) de la plaque de dissipation thermique, laquelle forme une partie de la ligne de connexion vers la connexion d'électrode, au moins les couches internes métalliques (2i, 3i) des plaques de dissipation thermique (2, 3) étant faites de cuivre,
**caractérisé par le fait que**
le coeur de carte de circuits imprimés (1) a une couche conductrice (5, 6) sur les deux côtés de la couche isolante (4), au moins une couche conductrice (5) est structurée au moins en sections et chaque couche conductrice (5, 6) est reliée au moins en sections à une couche interne métallique (2i, 3i) de la plaque de dissipation thermique (2, 3) par l'intermédiaire d'un revêtement intermédiaire métallique conducteur (16o, 16u), des contacts sortants s'étendent de la couche conductrice structurée vers les connexions d'électrode de l'au moins un composant de puissance (7, 17, 20), et la couche isolante (4) du coeur de carte de circuits imprimés (1) ainsi qu'une matière isolante (13) pour le remplissage ou le revêtement d'espaces intermédiaires des structures conductrices sont faites de la même matière isolante.

2. Module de puissance selon la revendication 1, **caractérisé par le fait qu'**au moins une connexion (7d) d'un composant de puissance (7) est reliée à la couche interne métallique (3i) d'une plaque de dissipation thermique (3) par l'intermédiaire d'une couche conductrice (6) et d'une couche intermédiaire métallique conductrice (16u).

3. Module de puissance selon l'une des revendications 1 ou 2, **caractérisé par le fait qu'**au moins une connexion (7d) d'un composant de puissance (7) est reliée à une couche conductrice (6) par l'intermédiaire d'un bloc métallique conducteur du courant et de la chaleur (18).

4. Module de puissance selon la revendication 3, **caractérisé par le fait qu'**une connexion (7d) est reliée à une couche conductrice (6) par l'intermédiaire d'une couche intermédiaire métallique (19).

5. Module de puissance selon l'une des revendications 1 à 4, **caractérisé par le fait que** les couches intermédiaires métalliques (16o, 16u ; 19) sont faites d'une matière en argent frittée à basse température.

6. Module de puissance selon l'une des revendications 1 à 5, **caractérisé par le fait que** le coeur de carte de circuits imprimés (1) comprend au moins un bloc métallique (10), qui est en liaison thermique et/ou électrique au moins avec des sections de la couche conductrice supérieure ou inférieure (5, 6).

7. Module de puissance selon la revendication 6, **caractérisé par le fait que** l'au moins un bloc métallique (10) est fait de cuivre.

8. Module de puissance selon l'une des revendications 1 à 7, **caractérisé par le fait qu'**il contient au moins une puce de transistor bipolaire à grille isolée (IGBT)/transistor à effet de champ métal-oxyde semiconducteur (MOSFET) (7), dont les bornes de source et de drain (7s, 7d) sont en liaison avec la couche interne métallique (2i, 3i), alors que la borne de grille (7g) est guidée hors du module par l'intermédiaire d'une piste conductrice (14).

9. Module de puissance selon l'une des revendications 1 à 8, **caractérisé par le fait qu'**il contient au moins une diode de puissance (17), dont la cathode ou l'anode (17k, 17a) sont en liaison avec la couche interne métallique (2i ou 3i).
